Europäisches Patentamt

European Patent Office

Office européen des brevets

(11) Veröffentlichungsnummer: **0 073 489**
A2

## (12) EUROPÄISCHE PATENTANMELDUNG

(21) Anmeldenummer: 82107862.3

(51) Int. Cl.³: **H 05 K 7/02**

(22) Anmeldetag: 26.08.82

(30) Priorität: 31.08.81 DE 3134399

(71) Anmelder: **SIEMENS AKTIENGESELLSCHAFT, Berlin und München Wittelsbacherplatz 2, D-8000 München 2 (DE)**

(43) Veröffentlichungstag der Anmeldung: **09.03.83 Patentblatt 83/10**

(72) Erfinder: **Thom, Günther, Ing. grad., Untertaxetweg 6, D-8035 Gauting (DE)**

(84) Benannte Vertragsstaaten: **AT FR GB SE**

(54) **Elektrische Baugruppe.**

(57) Die Anschlußstifte (4) eines Bauelementes (1) werden in plattierte Bohrungen (5) eines anderen Bauelementes (1 oder 2) eingepreßt und dadurch mit diesem elektrisch und mechanisch unmittelbar verbunden. Bei einer Baugruppe mit vielen Bauelementen verringert sich dadurch der Verdrahtungsaufwand, was insbesondere bei der Verwendung von gedruckten Leiterplatten (3) von Vorteil ist.

EP 0 073 489 A2

ACTORUM AG

SIEMENS AKTIENGESELLSCHAFT
Berlin und München

Unser Zeichen 0073489
VPA 81 P 5940 E

### Elektrische Baugruppe

Die Erfindung bezieht sich auf eine elektrische Baugruppe mit zumindest zwei elektrischen Bauelementen, von denen zumindest eines in plattierte oder unplattierte Bohrungen einpreßbare Kontaktstifte aufweist.

Derartige Bauelemente sind z.B. durch die deutsche Auslegeschrift 14 66 257 bekannt geworden. Die Kontaktstifte der Bauelemente sind in durchplattierte Bohrungen von Leiterplatten einsetzbar. In ihrer Einpreßzone sind sie mit scharfen Längskanten versehen, die sich in die Innenwand der Bohrung hineindrücken. Dadurch wird bei nicht zu starker Einpreßkraft ein fester Sitz der Kontaktstifte erreicht.

Nach der US-Patentschrift 40 50 769 ist es bekannt,einen Kantensteckverbinder einer Baugruppe mit rechtwinkelig zur Steckrichtung abgebogenen Kontaktstiften zu versehen und diese in entsprechende Bohrungen der Leiterplatte der Baugruppe einzupressen. Die Bohrungen können durchplattiert sein (Spalte 8 unten), so daß nicht nur ein mechanischer sondern auch elektrischer Kontakt ohne zusätzliche Kontaktierungsmaßnahmen wie Löten hergestellt werden kann.

Bisher war es ferner üblich, einzelne Bauelemente einer Baugruppe miteinander über z.B. die Leiterbahnen der Leiterplatte zu verbinden. Die Miniaturisierung der Bauelemente und die Verwendung von integrierten Schaltungen erhöht die Anzahl und Dichte der Kontaktstifte und erfor-

Khr 1 Gru / 07.08.1981

dert eine höhere Anzahl von Leiterbahnen auf der Leiterplatte, deren Verbindungskapazität jedoch begrenzt ist. Bei noch dichterer Belegung der Leiterplatte mit Bauelementen ist es erforderlich, eine Mehrlagenleiterplatte zu verwenden. Diese ist jedoch erheblich aufwendiger herzustellen.

Der Erfindung liegt die Aufgabe zugrunde, den Herstellungsaufwand für die Verbindung der Bauelemente einer Baugruppe untereinander zu verringern.

Diese Aufgabe wird durch die Erfindung gemäß Anspruch 1 gelöst. Durch die unmittelbare elektrische Verknüpfung zumindest eines Teiles der Bauelemente verringert sich die Anzahl der erforderlichen Verbindungswege auf der Leiterplatte. Diese wird bereits im Entwurf einfacher. Es verringert sich außerdem die Wahrscheinlichkeit, eine zweite Leiterplatte vorsehen zu müssen. Bei einer Baugruppe, die aus wenigen Bauelementen besteht, ist es möglich, diese z.B. durch Übereinanderstapeln miteinander zu verbinden, ohne daß eine Leiterplatte erforderlich ist. Durch das Einpressen der Kontaktstifte in die Bohrungen ist es möglich, nicht nur eine elektrische sondern auch eine mechanische Verbindung der Bauelemente unmittelbar herzustellen. Es versteht sich, daß die Kontaktstifte und die Aufnahmebohrungen ähnlich ausgebildet sind wie dies für das Einpressen in eine Leiterplatte erforderlich ist. Werden bei einem Bauelement, z.B. bei einer vielpoligen integrierten Schaltung einige Funktionen nicht benötigt, so ist es möglich, die entsprechenden Kontaktstifte zur Verstärkung der mechanischen Verbindung in entsprechende unplattierte Bohrungen einzupressen.

Die Ansprüche 2 bis 9 kennzeichnen vorteilhafte Weiterbildungen der Erfindung:

Durch die Weiterbildung nach Anspruch 2 und 3 ist es möglich,

0073489

verschiedenste Bauelemente ohne bauliche Veränderung miteinander zu verbinden. Es versteht sich, daß die den Kontaktstiften zugeordneten Bohrungen ebenfalls in einer Ebene und im Rastermaß angeordnet sind.

Durch die Weiterbildung nach Anspruch 4 und 5 ist es möglich, beide Bauelemente mit Bohrungen zu versehen, in die nur die tatsächlich benötigten Kontaktstifte hineingepreßt werden. Durch die Anordnung der Bauelemente zu beiden Seiten der Trägerplatte werden deren beide Seiten optimal ausgenutzt. Bei einer derartigen Anordnung können nicht nur anschlüsse der beiden Bauelemente unmittelbar miteinander, sondern auch beliebig mit in plattierten Öffnungen der Leiterplatte endenden Leiterbahnen verbunden werden. Dabei sind die Kontaktstifte durch Einpressen mit den plattierten Bohrungen verbunden.

Durch die Anordnung der Bohrungen und Kontaktstifte nach Anspruch 6 ist es möglich, alle Bauelemente mit der gleichen Konfiguration von Kontaktstiften und Bohrungen zu versehen und in beliebiger Kombination miteinander zu verbinden.

Die Weiterbildung nach Anspruch 7 ermöglicht eine noch höhere Anzahl von elektrischen Verbindungen zwischen den einzelnen Bauelementen.

Durch die Weiterbildung nach Anspruch 8 ist es möglich, eine Baugruppe mit einer sehr großen Anzahl von Leiterplatten zu versehen, ohne daß die Kontaktstifte erheblich verlängert werden müssen. Die Leiterplatten sind über die Bauelemente miteinander verbunden. Es ist auch möglich, Bauelemente mit bloßer Verbindungsfunktion vorzusehen, die an geeigneter Stelle der Leiterplatten zu plazieren sind. Durch die räumliche Trennung der Leiterplatten in unterschliedlichen Ebenen ist es möglich, die Anzahl der durchplattierten Bohrungen im Vergleich zu unmittelbar aneinan-

0073489

derliegenden Leiterplatten zu erhöhen.

Durch die Weiterbildung nach Anspruch 9 ist es möglich, die Belegungsdichte der Trägerplatte noch weiter zu erhöhen. Dabei ist es erforderlich, daß jedes Bauelement beidseitige Anschlüsse aufweist, die denen der benachbarten Bauelemente angepaßt sind. Bei einer derartigen Anordnung sind die elektrischen Verbindungen sehr kurz und somit schaltungstechnisch vorteilhaft.

Im folgenden wird die Erfindung anhand von in der Zeichnung dargestellten Ausführungsbeispielen näher erläutert. Die Fig. 1 und 2 zeigen eine schematisierte Seitenansicht und Draufsicht auf einen Teil einer elektrischen Baugruppe und Fig. 3 eine Seitenansicht einer anderen Baugruppe.

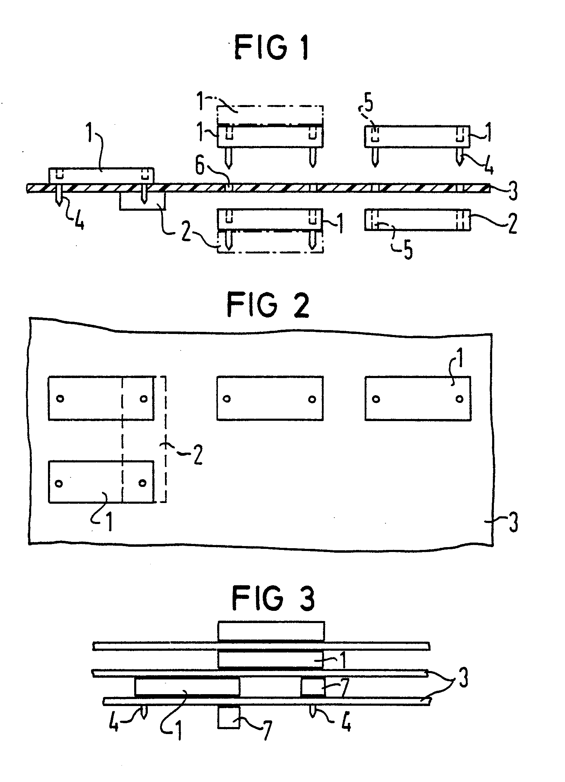

Nach den Fig. 1 und 2 sind Bauelemente 1 und 2 zu beiden Seiten einer Trägerplatte 3 angeordnet. Der Deutlichkeit halber ist ein Teil der Bauelemente 1 und 2 mit Abstand zur Trägerplatte dargestellt. Bei der fertigen Baugruppe liegen die Bauelemente 1 und 2 wie im linken Teil der Figur flach an der Trägerplatte 3 an. Die Bauelemente 1 und 2 sind mit Kontaktstiften 4 und/oder mit zu diesen passenden Bohrungen 5 versehen. Die Bohrungen sind so ausgebildet, daß die im Querschnitt z.B. quadratischen und scharfkantigen Kontaktstifte 4 in die Bohrungen hineingedrückt und darin durch Kantenpressung gehalten werden können. Die an ihrer Innenwand metallisierten Bohrungen 5 stellen ebenso wie die Kontaktstifte 4 elektrische Anschlüsse der Bauelemente 1 oder 2 dar. Die in die Bohrungen 5 eingepreßten Kontaktstifte 4 z.B. eines der Bauelemente 1 sind dann elektrisch mit den zugehörigen Bohrungen 5 des anderen Bauelementes z.B. 2 verbunden.

Die Trägerplatte 3 weist für die Kontaktstifte 4 Öffnungen 6 auf, durch die die Kontaktstifte 4 der anliegenden Bauelemente 1 so weit hindurchragen, daß sie zur Kontaktgabe hinreichend tief in die zugehörigen Bohrungen 5 des entsprechenden Bauelementes 1 oder 2 auf der anderen Seite der Leiterplatte eindringen können. Die Öffnungen 6 können als einfache Freimachungen ausgebildet sein, durch die die Einpreßkraft für die Kontaktstifte 4 nicht erhöht wird. Sie können aber auch den gleichen Durchmesser wie die Bohrungen 5 aufweisen, wodurch die Haltekraft erhöht wird. Die Trägerplatte 3 kann als Leiterplatte ausgebildet sein, bei der die Leiterbahnen in den durchplattierten Öffnungen 6 münden. Bei entsprechender Länge der Kontaktstifte ist es möglich, auch mehrere Leiterplatten übereinander zu legen.

Die Bauelemente 1 und 2 können einander paarweise zugeordnet sein. Sie können aber auch mit jeweils nur einem Kontaktstift 4 unmittelbar mit einem anderen Bauelement verbunden sein. Der andere Kontaktstift 4 kann dann z.B. mit einer Leiterbahn der Trägerplatte 3 verbunden sein. Es ist auch möglich, bei geeigneter Rasterteilung der Öffnungen 6 in der Trägerplatte 3 ein Bauelement 2 mit jeweils einem Kontaktstift 4 zweier benachbarter Bauelemente 1 unmittelbar zu verbinden.

Durch die strichpunktierten Linien in Fig. 1 ist angedeutet, daß auch mehrere Bauelemente 1 ohne dazwischenliegende Trägerplatte 3 unmittelbar übereinandergestapelt und elektrisch und mechanisch miteinander verbunden werden können.

Nach Fig. 3 sind mehrere Trägerplatten 3 in parallelen Ebenen mit Abstand zueinander angeordnet und durch dazwischenliegende Bauelemente 1 und 7 zusammengehalten und elektrisch miteinander verbunden. Da hier die Kontaktstifte 4 jeweils nur durch eine Trägerplatte 3 hindurchragen, benötigt man auch bei Verwendung mehrerer Trägerplatten nur eine Kontaktstiftlänge. Durch die Anordnung der Bauelemente 1 und 7 zwischen den Trägerplatten 3 wird

0073489

der zur Verfügung stehende Einbauraum erheblich vergrößert.

9 Patentansprüche
3 Figuren

## Patentansprüche

1. Elektrische Baugruppe mit zumindest zwei elektrischen Bauelementen, von denen zumindest eines in plattierten oder unplattierte Bohrungen einpreßbare Kontaktstifte aufweist, d a d u r c h   g e k e n n z e i c h n e t , daß das andere Bauelement (1 oder 2) mit zumindest zu einem Teil der Kontaktstifte (4) passenden Bohrungen (5) versehen ist und daß die beiden Bauelemente (1, 2) durch Einpressen der Kontaktstifte (4) in die Bohrungen (5) elektrisch und mechanisch unmittelbar miteinander verbunden sind.

2. Baugruppe nach Anspruch 1, d a d u r c h   g e k e n n z e i c h n e t , daß die Kontaktstifte (4) in einer Ebene angeordnet sind und ihre Abstände eine Rasterteilung aufweisen.

3. Baugruppe nach Anspruch 1 oder 2, d a d u r c h   g e k e n n z e i c h n e t , daß die beiden Bauelemente mit fluchtenden Bohrungen versehen sind, in die die Kontaktstifte hineingepreßt sind.

4. Baugruppe nach Anspruch 1, 2 oder 3, d a d u r c h   g e k e n n z e i c h n e t , daß die beiden Bauelemente (1, 2) zu beiden Seiten einer Trägerplatte (3) angeordnet sind, die entsprechende Öffnungen (6) für die Kontaktstifte (4) aufweist.

5. Baugruppe nach Anspruch 4, d a d u r c h   g e k e n n z e i c h n e t , daß die Kontaktsitfte (4) durch die Öffnungen (6) der Trägerplatte (3) hindurchgepreßt sind.

6. Baugruppe nach einem der vorhergehenden Ansprüche, d a d u r c h   g e k e n n z e i c h n e t, daß die Bauelemente mit drehsymmetrisch verteilten Bohrungen und Kontaktstiften versehen sind.

7. Baugruppe nach einem der vorhergehenden Ansprüche,
d a d u r c h   g e k e n n z e i c h n e t , daß die Trägerplatte aus mehreren Lagen einzelner Leiterplatten besteht, die zwischen den Bauelementen angeordnet sind.

8. Baugruppe nach einem der Ansprüche 1 bis 6, d a -
d u r c h   g e k e n n z e i c h n e t , daß mehrere Trägerplatten (3) mit Abstand in parallelen Ebenen angeordnet sind und daß zumindest ein Teil der Bauelemente (1
und 7) zwischen den Trägerplatten (3) angeordnet ist.

9. Baugruppe nach einem der Ansprüche 1 bis 8, d a -
d u r c h   g e k e n n z e i c h n e t , daß die Bauelemente unmittelbar übereinandergestapelt und mittels ihrer
Einpreßstifte verbunden sind.

0073489

1/1

FIG 1

FIG 2

FIG 3